# FASCICULE DE BREVET EUROPEEN

(11) **EP 3 401 647 B1**
(45) Date de publication et mention de la délivrance du brevet: **14.08.2019**
(21) Numéro de dépôt: 18169645.1
(22) Date de dépôt: 26.04.2018
(51) Int. Cl.: G01D 21/00, H02J 1/06, H02J 1/10, H02J 7/00, H02J 7/34, H02J 7/35

(54) **SYSTÈME DE MESURE DU NIVEAU DE PUISSANCE D'UNE SOURCE D'ÉNERGIE AMBIANTE**
MESSSYSTEM FÜR DEN LEISTUNGSPEGEL EINER UMWELTENERGIEQUELLE
SYSTEM FOR MEASURING THE POWER LEVEL OF AN AMBIENT ENERGY SOURCE

(30) Priorité: 09.05.2017 FR 1754047
(43) Date de publication de la demande: 14.11.2018
(73) Titulaire: Commissariat à l'Energie Atomique et aux Energies Alternatives, 75015 Paris (FR); STMicroelectronics (Crolles 2) SAS, 38920 Crolles (FR); STMICROELECTRONICS SA, 92120 Montrouge (FR)
(72) Inventeur: TROCHUT, Séverin, 73200 GILLY SUR ISERE (FR); MONFRAY, Stéphane, 38320 EYBENS (FR); BOISSEAU, Sébastien, 38130 ECHIROLLES (FR)
(74) Mandataire: Cabinet Beaumont

(56) Documents cités:
- EP-A1- 3 035 530
- US-A1- 2010 100 149
- US-A1- 2012 261 991
- US-A1- 2015 128 733

## Description

### Domaine

La présente demande concerne le domaine des systèmes de gestion ou de surveillance à base de modules de mesure sans fil. Elle vise plus particulièrement un système de mesure du niveau de puissance d'une source d'énergie ambiante comprenant un ou plusieurs modules de mesure sans fil.

### Exposé de l'art antérieur

On a déjà proposé des systèmes comprenant un ou plusieurs modules de mesure, chaque module comportant au moins un capteur d'un paramètre à mesurer, par exemple un capteur de température, un capteur de pression, un capteur de luminosité, un capteur d'accélération, un capteur de champ magnétique, etc., et comportant en outre un circuit de communication radio adapté à transmettre, à une unité de réception ou unité de centralisation du système, des données mesurées par son ou ses capteurs de paramètres. Chaque module comprend sa propre source d'alimentation électrique, qui peut être une batterie, ou encore un générateur à récupération d'énergie ambiante.

Un problème qui se pose dans de tels systèmes est celui de l'autonomie des modules de mesure. En effet, dans le cas de modules alimentés par batterie, lorsque la batterie est déchargée, le module ne peut plus fonctionner, et une opération de maintenance doit être prévue pour recharger ou remplacer la batterie. Dans le cas de modules intégrant un générateur à récupération d'énergie ambiante, l'autonomie du module est potentiellement infinie, mais le module ne peut fonctionner que lorsque le générateur reçoit suffisamment d'énergie ambiante. Par exemple, dans le cas d'un module alimenté par un générateur photoélectrique, le module ne peut fonctionner que lorsque la luminosité ambiante est suffisamment importante pour alimenter les capteurs et le circuit de communication du module.

Pour résoudre ces inconvénients, les demandeurs ont proposé dans la demande de brevet français n°16/59698, déposée le 7 octobre 2016, un système de mesure comprenant un ou plusieurs modules de mesure et une unité de centralisation. Dans ce système, chaque module de mesure comprend un circuit actif adapté à communiquer par liaison radio avec l'unité de centralisation. Chaque module de mesure comprend en outre un générateur électrique à récupération d'énergie ambiante adapté à convertir en électricité de l'énergie ambiante présente dans l'environnement du module de mesure. Chaque module comprend de plus un élément capacitif de stockage, par exemple un condensateur, adapté à stocker l'énergie électrique produite par le générateur. Dans chaque module de mesure, le circuit actif du module tire son énergie électrique d'alimentation de l'élément capacitif de stockage du module. Chaque module de mesure est configuré pour émettre, via son circuit actif, un signal radio d'indication d'événement, par exemple une impulsion ou une trame prédéfinie, à destination de l'unité de centralisation, à chaque fois que la tension aux bornes de son élément capacitif de stockage dépasse un seuil. L'unité de centralisation du système est adaptée à mesurer une grandeur temporelle représentative de la fréquence d'émission des signaux d'indication d'événement par chaque module de mesure, par exemple la période séparant les instants de réception de deux signaux d'indication d'événement successifs en provenance d'un même module de mesure, ou le nombre de signaux d'indication d'événement successifs reçus en provenance d'un même module de mesure dans un intervalle de temps prédéterminé. Connaissant les caractéristiques du module, et notamment le rendement énergétique de son générateur à récupération d'énergie ambiante et la consommation électrique de son circuit actif, l'unité de centralisation peut déduire de cette grandeur temporelle une information sur le niveau de puissance de la source d'énergie ambiante alimentant le module. Ainsi, l'unité de centralisation est adaptée à déduire d'une mesure représentative de la fréquence d'émission des signaux d'indication d'événement par un module de mesure, un paramètre relatif à l'environnement du module de mesure.

Un avantage de ce système réside dans l'autonomie pratiquement illimitée du ou des modules de mesure du système. En effet, tant que la source d'énergie ambiante exploitée par le ou les modules de mesure est suffisamment puissante pour charger l'élément capacitif de stockage du module, l'information sur la puissance de la source d'énergie ambiante, codée sous la forme d'une grandeur temporelle, est transmise à l'unité de centralisation. Si la puissance de la source d'énergie ambiante devient trop faible pour charger le condensateur du module, l'unité de centralisation ne reçoit plus de signaux d'indication d'événement de la part du module, et peut en déduire que le niveau de puissance de la source d'énergie ambiante alimentant le module est inférieur à un seuil correspondant au seuil minimal de sensibilité du système.

Il serait toutefois souhaitable d'améliorer au moins en partie certains aspects du système décrit dans la demande de brevet français n°16/59698 susmentionnée. En particulier, une limitation de ce système est que lorsque l'unité de centralisation ne reçoit aucun signal d'indication d'événement en provenance d'un module radio pendant une période de temps déterminée, elle ne peut pas déterminer si cette absence de signal résulte d'un niveau de puissance faible ou nul de la source d'énergie ambiante, ou d'une défaillance du module.

### Résumé

Ainsi, un mode de réalisation prévoit un module de mesure comprenant : un générateur électrique à récupération d'énergie ambiante ; un élément capacitif de stockage de l'énergie électrique produite par le générateur ; une batterie électrique ; une première branche reliant un noeud de sortie du générateur à une première électrode de l'élément capacitif de stockage ; une deuxième branche reliant une première borne de la batterie à la première électrode de l'élément capacitif de stockage ; et un circuit actif adapté à émettre un signal radio d'indication d'événement à chaque fois que la tension aux bornes de l'élément capacitif de stockage dépasse un premier seuil, dans lequel, en fonctionnement, l'élément capacitif de stockage reçoit simultanément, sur sa première électrode, un premier courant de charge provenant du générateur via la première branche, et un deuxième courant de charge provenant de la batterie via la deuxième branche.

Selon un mode de réalisation, la première branche comprend une première résistance et la deuxième branche comprend une deuxième résistance.

Selon un mode de réalisation, la deuxième branche comprend un circuit de protection de la batterie contre une sur-décharge.

Selon un mode de réalisation, le circuit de protection de la batterie contre une sur-décharge comprend un transistor reliant la première borne de la batterie à la première électrode de l'élément capacitif de stockage, et un circuit adapté à commander ce transistor à l'état passant lorsque la tension aux bornes de la batterie est supérieure à une limite basse en dessous de laquelle la batterie risquerait d'être endommagée, et à l'état bloqué lorsque la tension aux bornes de la batterie est inférieure à ladite limite basse.

Selon un mode de réalisation, la première branche comprend une diode orientée dans le sens direct entre le noeud de sortie du générateur et la première électrode de l'élément capacitif de stockage.

Selon un mode de réalisation, la deuxième branche comprend une diode orientée dans le sens direct entre la première borne de la batterie et la première électrode de l'élément capacitif de stockage.

Selon un mode de réalisation, le module comprend en outre une troisième branche reliant le noeud de sortie du générateur à la première borne de la batterie.

Selon un mode de réalisation, la troisième branche comprend un circuit de protection de la batterie contre une surcharge.

Selon un mode de réalisation, le circuit de protection de la batterie contre une surcharge comprend un transistor reliant le noeud de sortie du générateur à la première borne de la batterie, et un circuit adapté à commander ce transistor à l'état passant lorsque la tension aux bornes de la batterie est inférieure à une limite haute au-dessus de laquelle la batterie risquerait d'être endommagée, et à l'état bloqué lorsque la tension aux bornes de la batterie est supérieure à ladite limite haute.

Selon un mode de réalisation, la troisième branche comprend en outre un circuit de limitation du courant de charge appliqué à la batterie.

Selon un mode de réalisation, le circuit de limitation de courant comprend un transistor et un circuit adapté à commander ce transistor en régime linéaire de façon que la résistance du transistor soit d'autant plus élevée que le courant appliqué par le générateur dans la troisième branche est élevé.

Selon un mode de réalisation, la troisième branche comprend en outre une diode orientée dans le sens direct entre le noeud de sortie du générateur et la première borne de la batterie.

Selon un mode de réalisation, le circuit actif a un noeud d'alimentation relié à la première électrode de l'élément capacitif de stockage par l'intermédiaire d'un interrupteur, et le module comprend un circuit de contrôle adapté à commander la fermeture de l'interrupteur lorsque la tension aux bornes de l'élément capacitif dépasse ledit premier seuil.

Selon un mode de réalisation, le circuit de contrôle est en outre adapté à commander la réouverture de l'interrupteur lorsque la tension aux bornes de l'élément capacitif passe sous un deuxième seuil inférieur au premier seuil.

Un autre mode de réalisation prévoit un système comportant un ou plusieurs modules de mesure tels que définis ci-dessus, et une unité de centralisation adaptée à recevoir les signaux d'indication d'événement émis par chaque module, et à mesurer une grandeur temporelle représentative de la fréquence d'émission des signaux d'indication d'événement par chaque module.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique simplifié d'un exemple d'un mode de réalisation d'un module de mesure du niveau de puissance d'une source d'énergie ambiante ;
la figure 2 est un schéma électrique illustrant plus en détail un exemple de réalisation d'un circuit de comparaison d'une tension à un seuil du module de la figure 1 ;
la figure 3 est un schéma électrique illustrant plus en détail un exemple de réalisation d'un circuit de limitation de courant, d'un circuit de protection contre une surcharge, et d'un circuit de protection contre une sur-décharge, du module de la figure 1 ;
la figure 4 est un schéma électrique illustrant un autre exemple de réalisation du circuit de protection contre une surcharge décrit en relation avec la figure 3 ;
la figure 5 est un schéma électrique illustrant un autre exemple de réalisation du circuit de protection contre une surcharge et du circuit de protection contre une sur-décharge décrits en relation avec la figure 3 ;
la figure 6 est un schéma électrique illustrant un autre exemple de réalisation du circuit de protection contre une surcharge et du circuit de protection contre une sur-décharge décrits en relation avec la figure 3 ;
la figure 7 est un schéma électrique illustrant un autre exemple de réalisation du circuit de limitation de courant et du circuit de protection contre une surcharge décrits en relation avec la figure 3 ; et
la figure 8 est un schéma électrique illustrant un autre exemple de réalisation du circuit de limitation de courant, du circuit de protection contre une surcharge et du circuit de protection contre une sur-décharge décrits en relation avec la figure 3.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les systèmes de mesure décrits ci-après comprennent un ou plusieurs modules de mesure, et une unité de réception aussi appelée unité de centralisation, adaptée à recevoir des signaux radio émis par les modules de mesure. La réalisation de l'unité de centralisation n'a pas été détaillée, celle-ci étant à la portée de l'homme du métier à partir des indications fonctionnelles de la présente description. De plus, la réalisation des circuits de communication radio des modules de mesure n'a pas été détaillée, les modes de réalisation décrits étant compatibles avec les circuits de communication radio utilisés dans les modules de mesure sans fil connus. Dans la présente description, on utilisera le terme "connecté" pour désigner une liaison électrique directe, sans composant électronique intermédiaire, par exemple au moyen d'une piste conductrice, et le terme "couplé" ou le terme "relié", pour désigner soit une liaison électrique directe (signifiant alors "connecté") soit une liaison via un ou plusieurs composants intermédiaires (résistance, condensateur, etc.). Sauf précision contraire, les expressions "approximativement", "sensiblement", et "de l'ordre de" signifient à 10 % près, de préférence à 5 % près.

Selon un aspect d'un mode de réalisation, on prévoit un système de mesure du niveau de puissance d'une source d'énergie ambiante similaire à celui décrit dans la demande de brevet français n°16/59698 susmentionnée, mais dans lequel chaque module de mesure comprend en outre une batterie électrique permettant au module de continuer à envoyer des signaux à l'unité de centralisation même quand le niveau de puissance de la source d'énergie ambiante alimentant le générateur à récupération d'énergie ambiante du module devient trop faible pour charger son élément capacitif de stockage.

Plus particulièrement, dans les modes de réalisation décrits, en fonctionnement normal, l'élément capacitif de stockage de chaque module de mesure reçoit simultanément un premier courant de charge provenant du générateur à récupération d'énergie ambiante du module, et un deuxième courant de charge provenant de la batterie du module. Le courant de charge provenant de la batterie est sensiblement constant, tandis que le courant de charge provenant du générateur varie en fonction du niveau de puissance de la source d'énergie ambiante alimentant le générateur du module. La vitesse de chargement du condensateur, et par conséquent la fréquence d'émission des signaux d'indication d'événement par le module, varient donc en fonction du niveau de puissance de la source d'énergie ambiante. Plus particulièrement, plus le niveau de puissance de la source d'énergie ambiante est élevé, plus la fréquence d'émission des signaux d'indication d'événement par le module est élevée, et inversement. Lorsque le niveau de puissance de la source d'énergie ambiante est nul ou négligeable, l'élément capacitif de stockage du module ne reçoit plus que le courant provenant de la batterie. La fréquence d'émission des signaux d'indication d'événement par le module est alors égale à une valeur minimale Fmin dépendant uniquement des caractéristiques du module.

Ainsi, en mesurant une grandeur temporelle représentative de la fréquence d'émission des signaux d'indication d'événement émis par chaque module de mesure, par exemple la période séparant les instants de réception de deux signaux d'indication d'événement successifs en provenant du module de mesure, ou le nombre de signaux d'indication d'événement successifs reçus en provenance du module de mesure dans un intervalle de temps prédéterminé, l'unité de centralisation du système peut déterminer le niveau de puissance de la source d'énergie ambiante alimentant le générateur du module. Lorsque l'unité de centralisation ne reçoit aucun signal d'indication d'événement pendant une période prédéterminée supérieure à 1/Fmin, elle peut en déduire que le module est défaillant ou que sa batterie est déchargée.

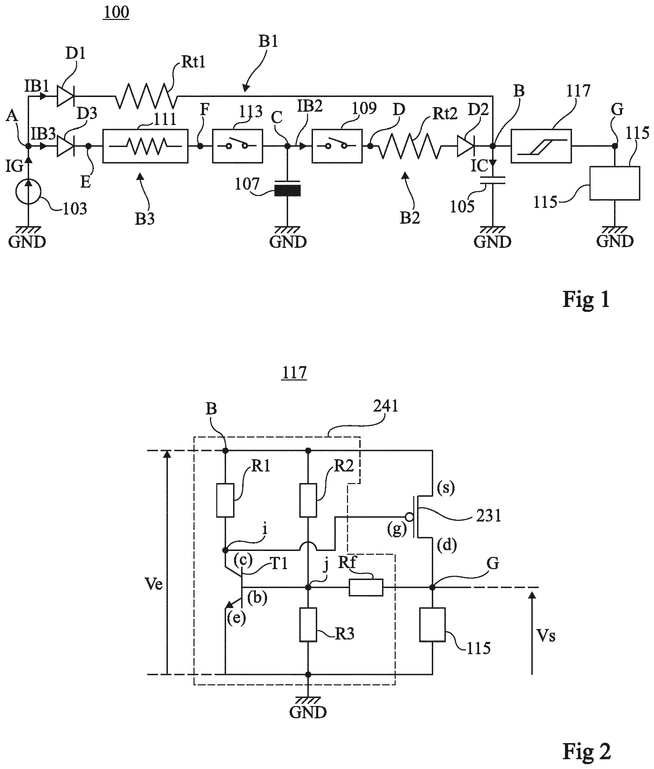

La figure 1 est un schéma électrique simplifié d'un exemple de mode de réalisation d'un module 100 de mesure du niveau de puissance d'une source d'énergie ambiante.

Le module de mesure 100 comprend un générateur à récupération d'énergie ambiante 103 adapté à fournir, sur un noeud A du module, un courant Ig fonction du niveau de puissance d'une source d'énergie ambiante. Sur la figure 1, le générateur 103 a été représenté sous la forme d'une source de courant reliant un noeud GND d'application d'un potentiel de référence du module, par exemple la masse, au noeud A. A titre d'exemple, le générateur 103 est un générateur à récupération d'énergie lumineuse, comprenant par exemple une ou plusieurs cellules photovoltaïques, un générateur à récupération d'énergie mécanique, un générateur à récupération d'énergie thermique, ou un générateur à récupération d'énergie électromagnétique. Les modes de réalisation décrits ne se limitent toutefois pas à ces exemples particuliers.

Le module de mesure 100 comprend en outre un élément capacitif de stockage 105, par exemple un condensateur, adapté à stocker au moins une partie de l'énergie électrique produite par le générateur 103. Dans cet exemple, l'élément capacitif 105 a une première électrode reliée (par exemple connectée) à un noeud B du module, et une deuxième électrode reliée (par exemple connectée) au noeud GND.

Le module de mesure 100 comprend en outre une première branche B1 reliant le noeud A au noeud B. Dans cet exemple, la branche B1 comprend une résistance Rt1 ayant une première extrémité reliée au noeud A et une deuxième extrémité reliée au noeud B. Dans l'exemple de la figure 1, la branche B1 comprend en outre une diode D1 reliée en série avec la résistance Rt1, la diode D1 étant orientée dans le sens direct entre les noeuds A et B, c'est-à-dire ayant son anode côté noeud A et sa cathode côté noeud B. Plus particulièrement, dans l'exemple représenté, l'anode de la diode D1 est connectée au noeud A, la cathode de la diode D1 est connectée à la première extrémité de la résistance Rt1, et la deuxième extrémité de la résistance Rt1 est connectée au noeud B.

Le module de mesure 100 comprend en outre une batterie électrique 107 ayant une borne positive reliée (par exemple connectée) à un noeud C du module, et une borne négative reliée (par exemple connectée) au noeud GND. La batterie 107 est par exemple une batterie lithium-ion, par exemple une batterie en couches minces à électrolyte solide. Plus généralement, tout autre type d'accumulateur électrochimique peut être utilisé.

Le module de mesure 100 comprend en outre une deuxième branche B2 reliant le noeud C au noeud B. Dans cet exemple, la branche B2 comprend une résistance Rt2 ayant une première extrémité reliée au noeud C et une deuxième extrémité reliée au noeud B. Dans l'exemple de la figure 1, la branche B2 comprend en outre une diode D2 reliée en série avec la résistance Rt2, la diode D2 étant orientée dans le sens direct entre les noeuds C et B. Dans cet exemple, la branche B2 comprend en outre un circuit 109 de protection de la batterie 107 contre une sur-décharge, c'est-à-dire un circuit adapté à interrompre la décharge de la batterie 107 dans l'élément capacitif de stockage 105 lorsque la tension de la batterie 107 atteint un seuil bas en-dessous duquel la batterie risquerait d'être endommagée. Dans l'exemple représenté, le circuit 109 a un premier noeud connecté au noeud C et un deuxième noeud connecté à un noeud D du module, la première extrémité de la résistance Rt2 étant connectée au noeud D, la deuxième extrémité de la résistance Rt2 étant connectée à l'anode de la diode D2, et la cathode de la diode D2 étant connectée au noeud B.

Le module de mesure 100 comprend en outre une troisième branche B3 reliant le noeud A au noeud C. Dans cet exemple, la branche B3 comprend un circuit 111 de limitation du courant de recharge appliqué à la batterie 107 par le générateur 103, et un circuit 113 de protection de la batterie 107 contre une surcharge, c'est-à-dire un circuit adapté à interrompre le courant de recharge appliqué à la batterie 107 par le générateur 103 lorsque la tension de la batterie 107 atteint un seuil haut au-dessus duquel la batterie risquerait d'être endommagée. Dans cet exemple, la branche B3 comprend en outre une diode D3 orientée dans le sens direct entre les noeuds A et C. Plus particulièrement, dans l'exemple représenté, la diode D3 a son anode connectée au noeud A et sa cathode connectée à un noeud E du module, le circuit 111 a un premier noeud connecté au noeud E et un deuxième noeud connecté à un noeud F du module, et le circuit 113 a un premier noeud connecté au noeud F et un deuxième noeud connecté au noeud C.

Le module de mesure 100 comprend en outre un circuit actif 115 adapté à communiquer par liaison radio avec l'unité de centralisation (non visible sur la figure 1) du système. A titre d'exemple, le circuit actif 115 comprend un module d'émission radio (non détaillé) adapté à communiquer avec l'unité de centralisation, par exemple selon un standard de communication radio de type Bluetooth ou IEEE 802.15.4, ou selon tout autre technologie de communication radio sans fil adaptée. Le circuit actif 115 peut en outre comprendre une unité de commande (non détaillée), par exemple un microcontrôleur, adaptée à commander le module radio. Le circuit actif 115 comprend des premier et deuxième noeuds d'alimentation, le premier noeud d'alimentation étant relié (par exemple connecté) au noeud GND et le deuxième noeud d'alimentation étant relié (par exemple connecté) à un noeud G du module.

Le module de mesure 100 comprend de plus un circuit 117 de comparaison d'une tension à un seuil comportant un premier noeud relié (par exemple connecté) au noeud B, un deuxième noeud relié (par exemple connecté) au noeud G, et un troisième noeud (non représenté en figure 1) relié (par exemple connecté) au noeud GND. Le circuit 117 est adapté à comparer la tension entre les noeuds B et GND, c'est-à-dire la tension aux bornes de l'élément capacitif de stockage 105, à un seuil prédéfini VH, et, lorsque cette tension est supérieure au seuil VH, à relier le noeud G au noeud B de façon à appliquer au circuit 115 une tension d'alimentation fournie par l'élément capacitif de stockage 105. Plus particulièrement, le circuit 117 comprend un comparateur à hystérésis adapté à commander la fermeture d'un interrupteur reliant le noeud B au noeud G lorsque la tension aux bornes de l'élément 105 passe au-dessus du seuil VH, puis à commander la réouverture de l'interrupteur, de façon à isoler le noeud G du noeud B, seulement lorsque la tension aux bornes de l'élément 105 redescend en dessous d'un seuil VL inférieur au seuil VH.

Le fonctionnement du module 100 de la figure 1 va maintenant être décrit.

Dans un premier temps, on considère un mode de fonctionnement dans lequel les circuits 111, 113 et 109 se comportent comme des interrupteurs fermés. Autrement dit, on considère que les noeuds E, F, C et D du module 100 sont connectés.

Le générateur à récupération d'énergie ambiante 103 du module fournit un courant IG d'autant plus élevé que le niveau de puissance de la source d'énergie ambiante alimentant le module est élevé. Une première partie IB1 du courant IG charge directement l'élément capacitif de stockage 105 en passant par la branche B1, et une seconde partie IB3 (sensiblement égale à IG-IB1 dans cet exemple) du courant IG circule dans la branche B3 en direction du noeud C, et vient notamment charger la batterie 107. Le courant de charge total IC reçu par l'élément capacitif de stockage 105 est la somme du courant IB1 et d'un courant IB2 provenant de la branche B2. Le courant IB2 provient au moins pour partie de la batterie 107, et éventuellement, pour une autre partie, directement de la branche B3.

Ainsi, bien que l'élément capacitif de stockage 105 reçoive en permanence un courant de charge en provenance de la batterie 107, ce courant ne constitue qu'une partie du courant de charge total IC de l'élément 105, l'autre partie du courant IC provenant directement (c'est-à-dire sans passer par la batterie 107) du générateur 103. La vitesse de chargement de l'élément 105 est donc fonction du niveau de puissance de la source d'énergie ambiante alimentant le module. Lorsque la tension aux bornes de l'élément capacitif de stockage 105 passe au-dessus du seuil VH, le circuit de comparaison 117 relie le noeud B au noeud G. Le circuit actif 115 est alors alimenté par l'élément capacitif de stockage 105. Le circuit actif 115 est configuré pour, lorsqu'il reçoit une tension d'alimentation après une période d'inactivité, émettre un signal radio d'indication d'événement à destination de l'unité de centralisation. L'énergie électrique consommée par le circuit actif 115 pendant cette phase provoque la décharge de l'élément capacitif de stockage 105 jusqu'au seuil bas VL du circuit 117. Le circuit 117 isole alors le noeud G du noeud B, de sorte que le circuit actif 115 cesse d'être alimenté. La charge de l'élément capacitif de stockage 105 reprend alors jusqu'à la prochaine commutation du circuit de comparaison 117.

La répartition entre la part de l'énergie électrique reçue par l'élément capacitif de stockage 105 en provenance directe du générateur à récupération d'énergie ambiante 103 et la part de l'énergie électrique reçue par l'élément capacitif de stockage 105 en provenance de la batterie 107 est fixée notamment par les valeurs des résistances Rt1 et Rt2. L'homme du métier saura ajuster cette répartition en fonction des besoins de l'application considérée. De préférence, la résistance Rt2 est nettement supérieure à la résistance Rt1, par exemple au moins dix fois plus élevée que la résistance Rt1, de façon que, pour un niveau de puissance moyen de la source d'énergie ambiante, la part de l'énergie électrique reçue par l'élément capacitif de stockage 105 en provenance directe du générateur 103 soit prépondérante devant la part de l'énergie électrique reçue par l'élément capacitif de stockage 105 en provenance de la batterie 107. A titre d'exemple, la résistance Rt2 est choisie de façon que, lorsque le niveau de puissance de la source d'énergie ambiante alimentant le module est nul ou négligeable et lorsque la batterie 107 est chargée, la vitesse de charge de l'élément capacitif de stockage 105 soit telle que la période Tmax = 1/Fmin entre deux émissions successives d'un signal d'indication d'événement par le circuit actif 115 soit supérieure ou égale à 1 mn, par exemple supérieure ou égale à 10 mn, par exemple supérieure ou égale à 30 mn. De préférence, lorsque le niveau de puissance de la source d'énergie ambiante alimentant le module est moyen, c'est-à-dire égal à la moitié de la puissance maximale pouvant être délivrée par la source d'énergie ambiante, et lorsque la batterie 107 est chargée, la période entre deux émissions successives d'un signal d'indication d'événement par le circuit actif 115 est au moins 10 fois plus faible et de préférence au moins 100 fois plus faible que la période Tmax, par exemple inférieure ou égale à 10 secondes, par exemple inférieure ou égale à 5 secondes.

Dans l'exemple de la figure 1, les diodes D1, D2 et D3 permettent notamment d'éviter une décharge de la batterie 107 dans l'élément capacitif de stockage 105 par les branches B3 et B1, ou une décharge de l'élément capacitif de stockage 105 dans la batterie 107 par la branche B2 ou par les branches B1 et B3 ou encore une décharge de l'élément capacitif de stockage 105 ou de la batterie 107 dans le générateur.

Le circuit 109 du module de la figure 1 a pour fonction de protéger la batterie 107 contre une sur-décharge, qui pourrait par exemple survenir si le niveau de puissance de la source d'énergie ambiante alimentant le module restait nul ou négligeable pendant une longue période, provoquant une décharge complète de la batterie dans l'élément capacitif de stockage 105. Le circuit 109 est adapté à interrompre la circulation du courant dans la branche B2 lorsque la tension de la batterie atteint une limite basse prédéfinie en dessous de laquelle la batterie risquerait d'être endommagée.

Le circuit 113 du module de la figure 1 a pour fonction de protéger la batterie 107 contre une surcharge, qui pourrait par exemple survenir si le niveau de puissance de la source d'énergie ambiante alimentant le module restait anormalement élevé pendant une longue période. Le circuit 113 est adapté à interrompre la circulation du courant dans la branche B3 lorsque la tension de la batterie atteint une limite haute prédéfinie au-dessus de laquelle la batterie risquerait d'être endommagée.

Le circuit 111 du module de la figure 1 a quant à lui pour fonction de limiter en intensité le courant de recharge appliqué à la batterie 107, notamment pour éviter une dégradation de la batterie dans le cas où le niveau de puissance de la source d'énergie ambiante alimentant le module serait particulièrement élevé. On notera que le circuit de limitation de courant 111 se comporte comme une résistance, et influe donc aussi, avec les résistances Rt1 et Rt2, sur la répartition du courant IG produit par le générateur 103 entre les branches B1 et B3 du module.

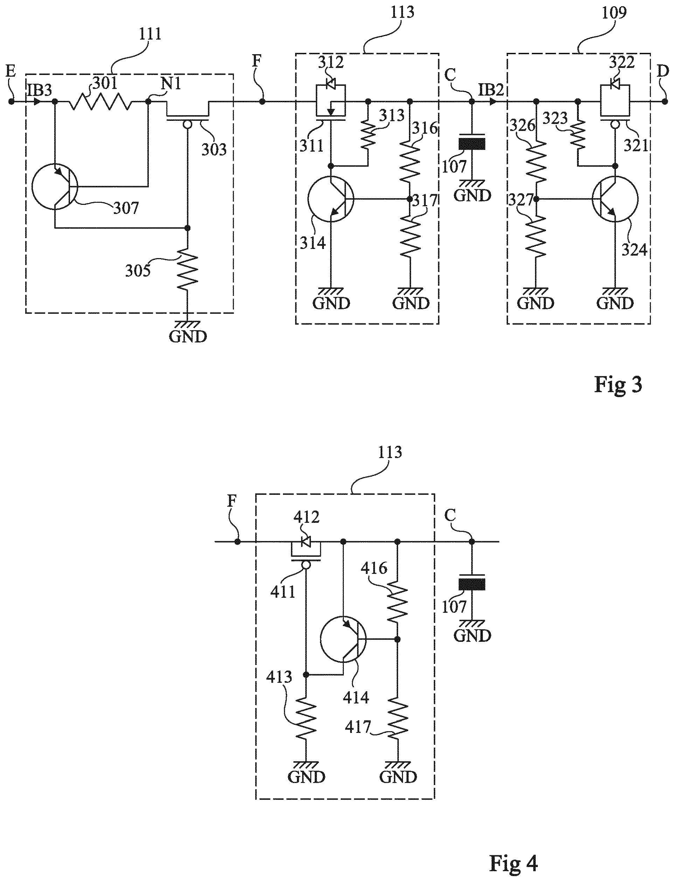

Des exemples de réalisation des circuits de protection 109 et 113 et du circuit de limitation de courant 111 vont être décrits ci-après en relation avec les figures 3 à 8. On notera toutefois que les circuits 109, 111 et 113 sont optionnels. A titre de variante, tous ou certains de ces circuits peuvent être omis, auquel cas le noeud E peut être connecté au noeud F et/ou le noeud F peut être connecté au noeud C, et/ou le noeud C peut être connecté au noeud D.

La figure 2 est un schéma électrique illustrant plus en détail un exemple de réalisation du circuit 117 du module de mesure 100 de la figure 1. Sur la figure 2, seuls le circuit 117 et le circuit actif 115 du module ont été représentés.

Le circuit 117 comprend un interrupteur 231 reliant le noeud B au noeud G, ainsi qu'un circuit 241 de commande de l'interrupteur 231.

Le circuit de commande 241 de la figure 2 comprend une première branche comportant une résistance R1 et un transistor T1 en série entre les noeuds d'entrée B et GND du circuit 117. Sur la figure 2, on a désigné par la référence Ve la tension d'entrée appliquée entre les noeuds B et GND, correspondant à la tension aux bornes de l'élément capacitif de stockage 105 (non visible sur la figure 2) du module. Dans l'exemple représenté, la résistance R1 a une première extrémité reliée au noeud B et une deuxième extrémité reliée à un noeud de sortie i du circuit de commande 241, et le transistor T1 a un premier noeud de conduction relié au noeud i et un deuxième noeud de conduction relié au noeud GND. Dans l'exemple représenté, le transistor T1 est un transistor bipolaire de type NPN, dont le collecteur (c) est relié au noeud i et dont l'émetteur (e) est relié au noeud GND.

Le circuit 241 de la figure 2 comprend en outre une deuxième branche parallèle à la première branche, comportant deux résistances R2 et R3 en série entre les noeuds B et GND. Plus particulièrement, dans l'exemple représenté, la résistance R2 a une première extrémité reliée au noeud B et une deuxième extrémité reliée à un noeud j, et la résistance R3 a une première extrémité reliée au noeud j et une deuxième extrémité reliée au noeud GND. Les résistances R2 et R3 forment un pont diviseur de tension. Le noeud j, ou point milieu du pont diviseur, est relié à un noeud de commande du transistor T1, à savoir la base (b) du transistor T1 dans l'exemple représenté.

Le circuit 241 comprend en outre une résistance Rf ayant une première extrémité reliée au noeud j et une deuxième extrémité reliée au noeud d'alimentation G du circuit actif 115.

Dans l'exemple de la figure 2, l'interrupteur 231 est un transistor ayant un premier noeud de conduction relié au noeud B, un deuxième noeud de conduction relié au noeud G, et un noeud de commande relié au noeud i. Dans l'exemple représenté, le transistor 231 est un transistor MOS à canal P dont la source (s) est reliée au noeud B, dont le drain (d) est relié au noeud G, et dont la grille (g) est reliée au noeud i.

Les noeuds G et GND sont des noeuds de fourniture d'une tension de sortie Vs du circuit 117, correspondant à la tension d'alimentation du circuit actif 115 du module.

Le fonctionnement du circuit de la figure 2 est le suivant. Lorsque la tension d'entrée Ve est basse, la tension aux bornes de la résistance R3 du pont diviseur n'est pas suffisante pour mettre en conduction le transistor T1. Le transistor T1 est donc bloqué. La tension aux bornes de la résistance R1, correspondant à la tension grille-source du transistor 231 dans cet exemple, est alors sensiblement nulle. Le transistor 231 est donc bloqué. Le courant traversant la charge formée par le circuit actif 115 est alors sensiblement nul, et le circuit 115 n'est pas alimenté. La tension de sortie Vs est alors approximativement nulle.

L'élément résistif Rf contribue alors à abaisser le potentiel du noeud j en le tirant vers celui du noeud G (alors sensiblement égal à celui du noeud GND), et renforce donc le blocage du transistor T1.

Lorsque la tension Ve augmente jusqu'à franchir un seuil VH, la tension aux bornes de la résistance R3 atteint le seuil de mise en conduction du transistor T1. Le transistor T1 devient alors passant, et un courant circule dans la branche comportant la résistance R1 et le transistor T1. La tension aux bornes de la résistance R1, ou tension source-grille du transistor 231 dans cet exemple, augmente alors jusqu'à atteindre le seuil de mise en conduction du transistor 231. Le transistor 231 devient donc lui aussi passant. La charge formée par le circuit actif 115 est alors alimentée, et la tension Vs devient sensiblement égale à la tension d'entrée Ve (à la chute de tension du transistor 231 près).

L'élément résistif Rf tend alors à rehausser le potentiel du noeud j en le tirant vers celui du noeud G (alors sensiblement égal à celui du noeud B), et contribue donc au maintien à l'état passant du transistor T1.

Lorsque la tension Ve redescend sous un seuil VL inférieur au seuil VH, la tension aux bornes de la résistance R3 n'est plus suffisante pour maintenir le transistor T1 à l'état passant. Le transistor T1 se bloque donc, et la tension aux bornes de la résistance R1 devient sensiblement nulle, entrainant le blocage du transistor 231. Il en résulte que le circuit actif 115 n'est plus alimenté, et la tension Vs devient sensiblement nulle.

A titre de variante, l'élément résistif Rf peut être remplacé par un élément capacitif, ou par une association série ou parallèle d'un élément résistif et d'un élément capacitif.

On notera qu'un circuit de comparaison d'une tension à un seuil similaire à celui de la figure 2 est décrit dans la demande de brevet européen EP3035530, ainsi que dans la demande de brevet américain correspondante US20161728 98.

Les modes de réalisation décrits ne se limitent pas à l'exemple de réalisation du circuit 117 décrit en relation avec la figure 2. A titre de variante, le circuit 117 de la figure 2 peut être remplacé par tout autre circuit comportant un interrupteur reliant les noeuds B et G du module, et un circuit de commande adapté à comparer la tension aux bornes de l'élément capacitif de stockage 105 à un seuil et à commander la fermeture de l'interrupteur lorsque la tension aux bornes de l'élément 105 dépasse ce seuil. En particulier, les modes de réalisation décrits sont compatibles avec les diverses variantes de réalisation du circuit de la figure 2 décrites dans les demandes de brevet EP3035530 et US20161728 98 susmentionnées.

La figure 3 est un schéma électrique illustrant plus en détail un exemple de réalisation des branches B2 et B3 du module de mesure 100 de la figure 1. La figure 3 illustre plus particulièrement un exemple de réalisation des circuits 109, 111 et 113 du module de la figure 1. Sur la figure 3, seuls les circuits 109, 111 et 113 et la batterie 107 ont été représentés.

Dans cet exemple, le circuit de limitation de courant 111 comprend une résistance 301 en série avec un transistor MOS 303 entre les noeuds E et F du circuit. Plus particulièrement, dans l'exemple représenté, la résistance 301 a une première extrémité connectée au noeud E et une deuxième extrémité connectée à un noeud intermédiaire N1, et le transistor 303 a un premier noeud de conduction connecté au noeud N1 et un deuxième noeud de conduction connecté au noeud F. Dans l'exemple représenté, le transistor 303 est un transistor MOS à canal P. Le circuit 111 de la figure 3 comprend en outre une résistance 305 reliant la grille du transistor 303 au noeud GND. Plus particulièrement, dans l'exemple représenté, la résistance 305 a une première extrémité connectée à la grille du transistor 303 et une deuxième extrémité connectée au noeud GND. Le circuit 111 de la figure 3 comprend en outre un transistor bipolaire 307 dont les noeuds de conduction sont reliés respectivement au noeud E et à la grille du transistor 303, et dont la base est reliée au noeud N1. Dans l'exemple représenté, le transistor 307 est un transistor PNP dont l'émetteur est connecté au noeud E, dont le collecteur est connecté à la grille du transistor 303, et dont la base est connectée au noeud N1.

Le fonctionnement du circuit 111 de la figure 3 est le suivant. Lorsque le courant IB3 en provenance du générateur 103 du module est nul, la tension aux bornes de la résistance 301 est nulle, et il ne circule aucun courant dans la jonction base-émetteur du transistor 307. Le transistor 307 est donc bloqué, et le potentiel appliqué sur la grille du transistor 303 est sensiblement égal au potentiel du noeud GND. Le transistor 303 est donc passant. Lorsque le courant IB3 en provenance du générateur 103 augmente, la tension aux bornes de la résistance 301 augmente, ce qui conduit à polariser en direct la jonction émetteur-base du transistor 307. Lorsque le transistor 307 commence à conduire, le potentiel appliqué sur la grille du transistor 303 tend à s'élever, ce qui limite le courant circulant entre les noeuds E et F. Ainsi, le transistor 303 se comporte comme une résistance variable, commandée par le circuit formé par les résistances 301 et 305 et le transistor 307 pour présenter une valeur d'autant plus élevée que le courant IB3 en provenance du générateur 103 est élevé.

Dans l'exemple de la figure 3, le circuit 113 comprend un transistor MOS à déplétion 311 dont un premier noeud de conduction est relié au noeud F et dont un deuxième noeud de conduction est relié au noeud C. A titre d'exemple, le transistor 311 est un transistor de type N dont le drain est connecté au noeud F et dont la source est connectée au noeud C. Dans l'exemple de la figure 3, le circuit 113 comprend en outre une diode 312, correspondant par exemple à la diode intrinsèque source-drain du transistor 311, dont l'anode est connectée au noeud C et dont la cathode est connectée au noeud F. Le circuit 113 de la figure 3 comprend de plus une résistance 313 reliant la source et la grille du transistor 311, et un transistor bipolaire 314 dont les noeuds de conduction sont reliés respectivement à la grille du transistor 311 et au noeud GND. Plus particulièrement, dans l'exemple représenté, le transistor 314 est un transistor NPN dont l'émetteur est connecté au noeud GND et dont le collecteur est connecté à la grille du transistor 311, la résistance 313 ayant une première extrémité connectée à la grille du transistor 311 et une deuxième extrémité connectée à la source du transistor 311. Le circuit 113 de la figure 3 comprend de plus un pont diviseur de tension résistif comprenant deux résistances 316 et 317 en série entre le noeud C et le noeud GND, le point milieu entre les résistances 316 et 317 étant relié à la base du transistor 314. Plus particulièrement, dans l'exemple représenté, la résistance 316 a une première extrémité connectée au noeud C et une deuxième extrémité connectée à la base du transistor 314, et la résistance 317 a une première extrémité connectée à la base du transistor 314 et une deuxième extrémité connectée au noeud GND.

Le fonctionnement du circuit 113 de la figure 3 est le suivant. En l'absence de surcharge de la batterie, le transistor 314 est maintenu bloqué par le pont diviseur de tension formé par les résistances 316 et 317. Le transistor 311 est donc passant, et laisse circuler le courant en provenance du générateur 103 du noeud F vers le noeud C. Le pont diviseur de tension formé par les résistances 316 et 317 est dimensionné pour que le transistor 314 devienne passant lorsque la tension entre les noeuds C et GND atteint un seuil correspondant à la limite haute de tension au-dessus de laquelle la batterie risque d'être endommagée. Lorsque le transistor 314 devient passant, la grille du transistor 311 est mise à un potentiel sensiblement égal au potentiel du noeud GND, ce qui conduit à bloquer le transistor 311. Le courant IB3 en provenance du générateur 103 du module est alors interrompu et cesse d'alimenter la batterie 107.

Dans l'exemple de la figure 3, le circuit 109 comprend un transistor MOS 321 dont un premier noeud de conduction est relié au noeud C et dont un deuxième noeud de conduction est relié au noeud D. A titre d'exemple, le transistor 321 est un transistor à canal P dont le drain est connecté au noeud D et dont la source est connectée au noeud C. Dans l'exemple de la figure 3, le circuit 109 comprend en outre une diode 322, correspondant par exemple à la diode intrinsèque drain-source du transistor 321, dont l'anode est connectée au noeud D et dont la cathode est connectée au noeud C. Le circuit 109 de la figure 3 comprend de plus une résistance 323 reliant la source et la grille du transistor 321, et un transistor bipolaire 324 dont les noeuds de conduction sont reliés respectivement à la grille du transistor 321 et au noeud GND. Plus particulièrement, dans l'exemple représenté, le transistor 324 est un transistor NPN dont l'émetteur est connecté au noeud GND et dont le collecteur est connecté à la grille du transistor 321, et la résistance 323 a une première extrémité connectée à la grille du transistor 321 et une deuxième extrémité connectée à la source du transistor 321. Le circuit 109 de la figure 3 comprend de plus un pont diviseur de tension résistif comprenant deux résistances 326 et 327 en série entre le noeud C et le noeud GND, le point milieu entre les résistances 326 et 327 étant relié à la base du transistor 324. Plus particulièrement, dans l'exemple représenté, la résistance 326 a une première extrémité connectée au noeud C et une deuxième extrémité connectée à la base du transistor 324, et la résistance 327 a une première extrémité connectée à la base du transistor 324 et une deuxième extrémité connectée au noeud GND.

Le fonctionnement du circuit 109 de la figure 3 est le suivant. Lorsque la batterie est normalement chargée, le transistor 324 est maintenu passant par le pont diviseur de tension formé par les résistances 326 et 327. Le transistor 321 est donc passant, et laisse circuler le courant IB2 entre les noeuds C et D de la branche B2. Le pont diviseur de tension formé par les résistances 326 et 327 est dimensionné pour que le transistor 324 se bloque lorsque la tension entre les noeuds C et GND atteint un seuil correspondant à la limite basse de tension en-dessous de laquelle la batterie risque d'être endommagée. Lorsque le transistor 324 se bloque, la grille du transistor 321 est mise à un potentiel sensiblement égal au potentiel du noeud C, ce qui conduit à bloquer le transistor 321. Le courant IB2 circulant entre les noeuds C et D est alors interrompu et la batterie 107 cesse de se décharger.

La figure 4 est un schéma électrique illustrant un autre exemple de réalisation du circuit de protection contre une surcharge 113 décrit en relation avec la figure 3. Sur la figure 4, seuls le circuit 113 et la batterie 107 ont été représentés.

Dans l'exemple de la figure 4, le circuit 113 comprend un transistor MOS à canal P 411 dont la source est reliée (connecté dans l'exemple représenté) au noeud C et dont le drain est relié (connecté dans l'exemple représenté) au noeud F. Dans l'exemple de la figure 4, le circuit 113 comprend en outre une diode 412, correspondant par exemple à la diode intrinsèque source-drain du transistor 411, dont l'anode est connectée au noeud C et dont la cathode est connectée au noeud F. Le circuit 113 de la figure 4 comprend de plus une résistance 413 reliant la grille du transistor 411 au noeud GND, et un transistor bipolaire 414 dont les noeuds de conduction sont reliés respectivement au noeud C et à la grille du transistor 411. Plus particulièrement, dans l'exemple représenté, le transistor 414 est un transistor PNP dont l'émetteur est connecté au noeud C et dont le collecteur est connecté à la grille du transistor 411, et la résistance 413 a une première extrémité connectée à la grille du transistor 411 et une deuxième extrémité connectée au noeud GND. Le circuit 113 de la figure 4 comprend de plus un pont diviseur de tension résistif comprenant deux résistances 416 et 417 en série entre le noeud C et le noeud GND, le point milieu entre les résistances 416 et 417 étant relié à la base du transistor 414. Plus particulièrement, dans l'exemple représenté, la résistance 416 a une première extrémité connectée au noeud C et une deuxième extrémité connectée à la base du transistor 414, et la résistance 417 a une première extrémité connectée à la base du transistor 414 et une deuxième extrémité connectée au noeud GND.

Le fonctionnement du circuit 113 de la figure 4 est le suivant. En l'absence de surcharge de la batterie, le transistor 414 est maintenu bloqué par le pont diviseur de tension formé par les résistances 416 et 417. Le transistor 411 est donc passant, et laisse circuler le courant en provenance du générateur 103 du noeud F vers le noeud C. Le pont diviseur de tension formé par les résistances 416 et 417 est dimensionné pour que le transistor 414 devienne passant lorsque la tension entre les noeuds C et GND atteint un seuil correspondant à la limite haute de tension au-dessus de laquelle la batterie risque d'être endommagée. Lorsque le transistor 414 devient passant, la grille du transistor 411 est mise à un potentiel sensiblement égal au potentiel du noeud GND, ce qui conduit à bloquer le transistor 411. Le courant IB3 en provenance du générateur 103 du module est alors interrompu et cesse d'alimenter la batterie 107.

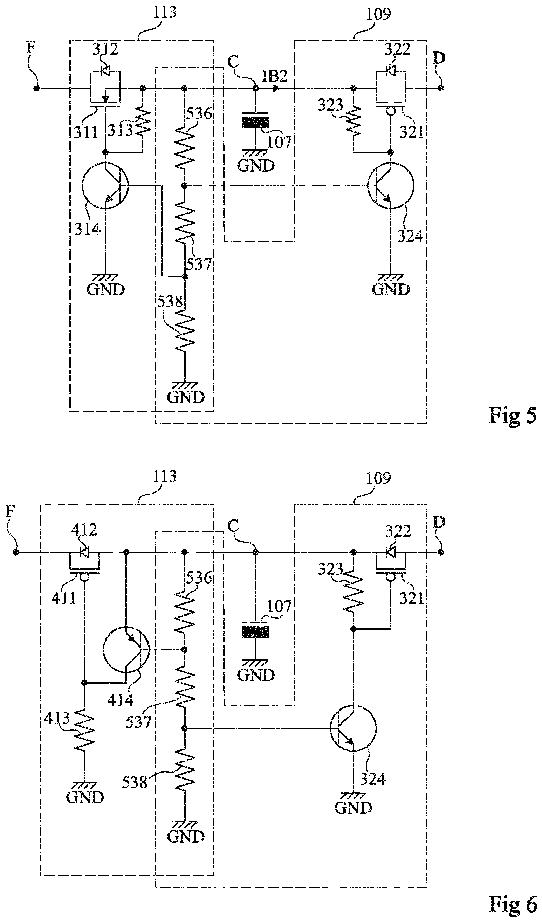

La figure 5 est un schéma électrique illustrant un autre exemple de réalisation du circuit 113 de protection contre une surcharge et du circuit 109 de protection contre une sur-décharge décrits en relation avec la figure 3. Sur la figure 5, seuls les circuits 113 et 109 et la batterie 107 ont été représentés.

Les circuits 113 et 109 de la figure 5 comprennent des éléments communs avec les circuits 113 et 109 de la figure 3. En particulier, les éléments 311, 312, 313, 314, 321, 322, 323 et 324 sont communs aux deux figures et sont agencés sensiblement de la même manière sur les deux figures. L'exemple de la figure 5 diffère de l'exemple de la figure 3 principalement en ce que, dans l'exemple de la figure 5, les ponts diviseurs de tension des circuits 113 et 109 sont mutualisés. Plus particulièrement, dans l'exemple de la figure 5, le pont diviseur de tension à sortie unique du circuit 113, formé par les résistances 316 et 317, et le pont diviseur de tension à sortie unique du circuit 109, formé par les résistances 326 et 327, sont remplacés par un pont diviseur de tension à deux sorties, commun aux circuits 113 et 109. Plus particulièrement, dans l'exemple de la figure 5, le pont diviseur de tension commun aux circuits 113 et 109 comprend trois résistances 536, 537 et 538 en série entre les noeuds C et GND, le point milieu entre les résistances 536 et 537 étant relié à la base du transistor 324, et le point milieu entre les résistances 537 et 538 étant relié à la base du transistor 314. Plus particulièrement, dans l'exemple représenté, le transistor 536 a une première extrémité connectée au noeud C et une deuxième extrémité connectée à la base du transistor 324, la résistance 537 a une première extrémité connectée à la base du transistor 324 et une deuxième extrémité connectée à la base du transistor 314, et la troisième résistance a une première extrémité connectée à la base du transistor 314 et une deuxième extrémité connectée au noeud GND.

Par rapport à l'exemple de la figure 3, un avantage de l'exemple de la figure 5 est qu'il permet d'économiser une résistance, et de réduire la consommation électrique globale des circuits 113 et 109 liée à la commande des transistors 314 et 324.

La figure 6 est un schéma électrique illustrant un autre exemple de réalisation du circuit 113 de protection contre une surcharge et du circuit 109 de protection contre une sur-décharge décrits en relation avec la figure 3. Sur la figure 6, seuls les circuits 113 et 109 et la batterie 107 ont été représentés.

L'exemple de réalisation de la figure 6 diffère de l'exemple de réalisation de la figure 5 principalement en ce que, dans l'exemple de la figure 6, les transistors 311 et 314, la diode 312 et la résistance 313 du circuit 113 sont remplacés par les transistors 411 et 414 la diode 412 et la résistance 413 du circuit 113 de la figure 4, agencés sensiblement de la même manière que dans l'exemple de la figure 4. Dans l'exemple de la figure 6, la base du transistor 324 est connectée au point milieu entre les résistances 537 et 538, et la base du transistor 414 est connectée au point milieu entre les résistances 536 et 537.

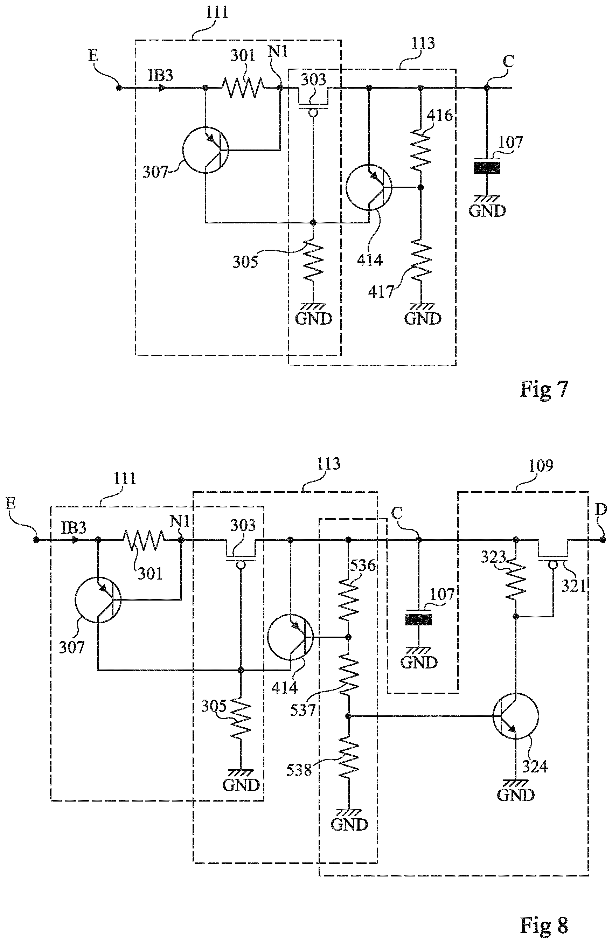

La figure 7 est un schéma électrique illustrant un autre exemple de réalisation du circuit de limitation de courant 111 et du circuit de protection contre une surcharge 113 décrits en relation avec la figure 3. Sur la figure 7, seuls les circuits 111 et 113 et la batterie 107 ont été représentés.

Dans l'exemple de la figure 7, le circuit 111 est identique au circuit 111 de la figure 3, et le circuit 113 est similaire au circuit 113 de la figure 4 mais partage des éléments avec le circuit 111. Plus particulièrement, dans l'exemple de la figure 7, les circuits 111 et 113 partagent un même transistor MOS et une même résistance reliant la grille du transistor MOS au noeud GND. Autrement dit, dans l'exemple de la figure 7, le transistor 411, la diode 412 et la résistance 413 du circuit 113 de la figure 4 sont omis. De plus, les noeuds F et C sont confondus, c'est-à-dire que le transistor 303 relie directement le noeud N1 au noeud C. Le transistor 414 a ses noeuds de conduction reliés respectivement au noeud C et à la grille du transistor 303. Comme dans l'exemple de la figure 4, le circuit 113 comprend un pont diviseur de tension résistif comprenant deux résistances 416 et 417 en série entre le noeud C et le noeud GND, le point milieu entre les résistances 416 et 417 étant relié à la base du transistor 414.

Là encore, la mutualisation des composants permet un gain en coût, en encombrement, et en consommation électrique.

La figure 8 est un schéma électrique illustrant un autre exemple de réalisation du circuit de limitation de courant 111, du circuit de protection contre une surcharge 113 et du circuit de protection contre une sur-décharge 109 décrits en relation avec la figure 3. Dans l'exemple de la figure 8, et toujours afin de minimiser le coût, l'encombrement, et la consommation électrique du module, les circuits 111 et 113 d'une part, et 113 et 109 d'autre part, partagent des éléments en communs. Sur la figure 8, seuls les circuits 111, 113 et 109 et la batterie 107 ont été représentés.

Dans l'exemple de la figure 8, les circuits 111 et 113 sont réalisés de façon similaire à ce qui a été décrit dans l'exemple de la figure 7, de façon à partager un unique transistor MOS 303 entre le noeud N1 et le noeud C. De plus, les circuits 113 et 109 sont réalisés de façon similaire à ce qui a été décrit dans l'exemple de la figure 6, de façon à partager un unique pont diviseur résistif à deux sorties. Autrement dit, dans l'exemple de la figure 8, la réalisation des circuits 111 et 113 diffère de ce qui a été décrit en relation avec la figure 7 uniquement en ce que le pont diviseur résistif à une sortie unique formé par les résistances 416 et 417 dans l'exemple de la figure 7, a été remplacé par le pont diviseur résistif à deux sorties de l'exemple de la figure 6, formé par les résistances 536, 537 et 538, le point milieu entre les résistances 536 et 537 étant connecté à la base du transistor 414. Le circuit 109 de la figure 8 est quant à lui identique au circuit 109 de la figure 6.

Des modes de réalisation particuliers ont été décrits. Diverses variantes et modifications apparaîtront à l'homme de l'art. En particulier, les modes de réalisation décrits ne se limitent pas aux exemples particuliers de réalisation des circuits 111, 113, 109 et 117 décrits en relation avec les figures 2 à 8. Plus généralement, l'homme du métier saura prévoir d'autres circuits adaptés à mettre en oeuvre les fonctions recherchées. On notera en particulier que le circuit de limitation de courant 111 du module de mesure peut être constitué d'une simple résistance fixe reliant le noeud E au noeud F.

Par ailleurs, et bien que cela n'ait pas été représenté sur les figures, le module de mesure 100 de la figure 1 peut en outre comprendre un circuit d'alimentation destiné à être couplé à une source d'alimentation électrique extérieure au module, pour permettre d'alimenter le module indépendamment du niveau de puissance de la source d'énergie ambiante lors d'opérations spécifiques de maintenance ou de test. A titre d'exemple, le circuit d'alimentation est connecté d'une part au noeud E et d'autre part au noeud G, et est adapté à appliquer sur les noeuds E et G des tensions d'alimentation, par exemple en vue de recharger la batterie 107 si celle-ci est totalement déchargée et/ou en vue d'alimenter le circuit actif 115 à des fins de test. Le circuit d'alimentation peut comporter une interface de couplage à une source d'énergie électrique extérieure, par exemple une interface filaire, par exemple de type USB, ou une interface par couplage inductif.

## Revendications

1. Module de mesure (100) comprenant :
un générateur électrique à récupération d'énergie ambiante (103) ;
un élément capacitif de stockage (105) de l'énergie électrique produite par le générateur ;
une batterie électrique (107) ;
une première branche (B1) reliant un noeud de sortie (A) du générateur (103) à une première électrode (B) de l'élément capacitif de stockage (105) ;
une deuxième branche (B2) reliant une première borne (C) de la batterie (107) à la première électrode de l'élément capacitif de stockage (105) ; et
un circuit actif (115) adapté à émettre un signal radio d'indication d'événement à chaque fois que la tension aux bornes de l'élément capacitif de stockage (105) dépasse un premier seuil,
dans lequel, en fonctionnement, l'élément capacitif de stockage (105) reçoit simultanément, sur sa première électrode, un premier courant de charge (IB1) provenant du générateur via la première branche, et un deuxième courant de charge (IB2) provenant de la batterie (107) via la deuxième branche.

2. Module selon la revendication 1, dans lequel la première branche (B1) comprend une première résistance (Rt1) et la deuxième branche (B2) comprend une deuxième résistance (Rt2).

3. Module selon la revendication 1 ou 2, dans lequel la deuxième branche (B2) comprend un circuit (109) de protection de la batterie (107) contre une sur-décharge.

4. Module selon la revendication 3, dans lequel le circuit (109) de protection de la batterie (107) contre une sur-décharge comprend un transistor (321) reliant la première borne (C) de la batterie (107) à la première électrode (B) de l'élément capacitif de stockage (105), et un circuit (323, 326, 327, 324 ; 536, 537, 538) adapté à commander ce transistor (321) à l'état passant lorsque la tension aux bornes de la batterie est supérieure à une limite basse en dessous de laquelle la batterie risquerait d'être endommagée, et à l'état bloqué lorsque la tension aux bornes de la batterie est inférieure à ladite limite basse.

5. Module selon l'une quelconque des revendications 1 à 4, dans lequel la première branche (B1) comprend une diode (D1) orientée dans le sens direct entre le noeud de sortie (A) du générateur (103) et la première électrode (B) de l'élément capacitif de stockage (105).

6. Module selon l'une quelconque des revendications 1 à 5, dans lequel la deuxième branche comprend une diode (D2) orientée dans le sens direct entre la première borne (C) de la batterie (107) et la première électrode de l'élément capacitif de stockage (105).

7. Module selon l'une quelconque des revendications 1 à 6, comprenant en outre une troisième branche (B3) reliant le noeud de sortie (A) du générateur (103) à la première borne (C) de la batterie (107).

8. Module selon la revendication 7, dans lequel la troisième branche (B3) comprend un circuit (113) de protection de la batterie (107) contre une surcharge.

9. Module selon la revendication 8, dans lequel le circuit (113) de protection de la batterie (107) contre une surcharge comprend un transistor (311 ; 411 ; 303) reliant le noeud de sortie (A) du générateur (103) à la première borne (C) de la batterie (107), et un circuit (313, 316, 317, 314 ; 413, 416, 417, 414 ; 536, 537, 538) adapté à commander ce transistor (311 ; 411 ; 303) à l'état passant lorsque la tension aux bornes de la batterie est inférieure à une limite haute au-dessus de laquelle la batterie risquerait d'être endommagée, et à l'état bloqué lorsque la tension aux bornes de la batterie est supérieure à ladite limite haute.

10. Module selon l'une quelconque des revendications 7 à 9, dans lequel la troisième branche (B3) comprend en outre un circuit (111) de limitation du courant de charge appliqué à la batterie (107).

11. Module selon la revendication 10, dans lequel le circuit de limitation de courant (111) comprend un transistor (303) et un circuit (301, 307; 305) adapté à commander ce transistor en régime linéaire de façon que la résistance du transistor soit d'autant plus élevée que le courant appliqué par le générateur (103) dans la troisième branche est élevé.

12. Module selon l'une quelconque des revendications 7 à 11, dans lequel la troisième branche comprend en outre une diode (D3) orientée dans le sens direct entre le noeud de sortie (A) du générateur (103) et la première borne (C) de la batterie (107).

13. Module selon l'une quelconque des revendications 1 à 12, dans lequel le circuit actif (115) a un noeud d'alimentation (G) relié à la première électrode (B) de l'élément capacitif de stockage (105) par l'intermédiaire d'un interrupteur (231), et dans lequel le module comprend un circuit de contrôle (241) adapté à commander la fermeture de l'interrupteur (231) lorsque la tension aux bornes de l'élément capacitif (105) dépasse ledit premier seuil.

14. Module selon la revendication 13, dans lequel le circuit de contrôle (241) est en outre adapté à commander la réouverture de l'interrupteur (231) lorsque la tension aux bornes de l'élément capacitif (105) passe sous un deuxième seuil inférieur au premier seuil.

15. Système comportant un ou plusieurs modules de mesure (100) selon l'une quelconque des revendications 1 à 14, et une unité de centralisation adaptée à recevoir les signaux d'indication d'événement émis par chaque module (100), et à mesurer une grandeur temporelle représentative de la fréquence d'émission des signaux d'indication d'événement par chaque module.

## Patentansprüche

1. Messeinheit (100), die folgendes aufweist:
einen elektrischen Umgebungsenergie-Rückgewinnungsgenerator (103);
ein Element (105) zum kapazitiven Speichern der durch den Generator erzeugten elektrischen Energie;
eine elektrische Batterie (107);
einen ersten Zweig (B1), der einen Ausgangsknoten (A) des Generators (103) mit einer ersten Elektrode (B) des kapazitiven Speicherelements (105) koppelt;
einen zweiten Zweig (B2), der einen ersten Anschluss (C) der Batterie (107) mit der ersten Elektrode des kapazitiven Speicherelements (105) koppelt; und
eine aktive Schaltung (115), die geeignet ist, ein Funkereignisanzeigesignal jedes Mal zu übertragen, wenn die Spannung über dem kapazitiven Speicherelement (105) einen ersten Schwellenwert überschreitet,
wobei das kapazitive Speicherelement (105) im Betrieb gleichzeitig an seiner ersten Elektrode einen ersten Ladestrom (IB1), der vom Generator über den ersten Zweig stammt, und einen zweiten Ladestrom (IB2), der von der Batterie (107) über den zweiten Zweig stammt, empfängt.

2. Einheit nach Anspruch 1, wobei der erste Zweig (B1) einen ersten Widerstand (Rt1) und der zweite Zweig (B2) einen zweiten Widerstand (Rt2) aufweist.

3. Einheit nach Anspruch 1 oder 2, wobei der zweite Zweig (B2) eine Schaltung (109) zum Schutz der Batterie (107) gegen eine Überladung aufweist.

4. Einheit nach Anspruch 3, wobei die Schaltung (109) zum Schutz der Batterie (107) vor einer Überladung einen Transistor (321) aufweist, der den ersten Anschluss (C) der Batterie (107) mit der ersten Elektrode (B) des kapazitiven Speicherelements (105) koppelt, und eine Schaltung (323, 326, 327, 324; 536, 537, 538), die geeignet ist, diesen Transistor (321) in den Ein-Zustand zu steuern, wenn die Spannung über der Batterie höher als eine untere Grenze ist, unterhalb derer die Batterie beschädigt werden könnte, und in den Aus-Zustand, wenn die Spannung über der Batterie niedriger als die untere Grenze ist.

5. Einheit nach einem der Ansprüche 1 bis 4, wobei der erste Zweig (B1) eine Diode (D1) aufweist, die in Vorwärtsrichtung zwischen dem Ausgangsknoten (A) des Generators (103) und der ersten Elektrode (B) des kapazitiven Speicherelements (105) ausgerichtet ist.

6. Einheit nach einem der Ansprüche 1 bis 5, wobei der zweite Zweig eine Diode (D2) aufweist, die in Vorwärtsrichtung zwischen dem ersten Anschluss (C) der Batterie (107) und der ersten Elektrode des kapazitiven Speicherelements (105) ausgerichtet ist.

7. Einheit nach einem der Ansprüche 1 bis 6, die ferner einen dritten Zweig (B3) aufweist, der den Ausgangsknoten (A) des Generators (103) mit dem ersten Anschluss (C) der Batterie (107) koppelt.

8. Einheit nach Anspruch 7, wobei der dritte Zweig (B3) eine Schaltung (113) zum Schutz der Batterie (107) gegen eine Überladung aufweist.

9. Einheit nach Anspruch 8, wobei die Schaltung (113) zum Schutz der Batterie (107) vor einer Überladung einen Transistor (311; 411; 303) aufweist, der den Ausgangsknoten (A) des Generators (103) mit dem ersten Anschluss (C) der Batterie (107) koppelt, und eine Schaltung (313, 316, 317, 314; 413, 416, 417, 414; 536, 537, 538), die geeignet ist, diesen Transistor (311; 411; 303) in den Ein-Zustand zu steuern, wenn die Spannung über der Batterie niedriger ist als eine Obergrenze, oberhalb derer die Batterie beschädigt werden könnte, und in den Aus-Zustand, wenn die Spannung über der Batterie höher ist als die Obergrenze.

10. Einheit nach einem der Ansprüche 7 bis 9, wobei der dritte Zweig (B3) ferner eine Schaltung (111) zum Begrenzen des an die Batterie (107) angelegten Ladestroms aufweist.

11. Einheit nach Anspruch 10, wobei die Strombegrenzungsschaltung (111) einen Transistor (303) und eine Schaltung (301, 307; 305) aufweist, die diesen Transistor im linearen Zustand steuern kann, so dass der Widerstand des Transistors umso höher ist, je höher der vom Generator (103) im dritten Zweig angelegte Strom ist.

12. Einheit nach einem der Ansprüche 7 bis 11, wobei der dritte Zweig ferner eine Diode (D3) aufweist, die in Vorwärtsrichtung zwischen dem Ausgangsknoten (A) des Generators (103) und dem ersten Anschluss (C) der Batterie (107) ausgerichtet ist.

13. Einheit nach einem der Ansprüche 1 bis 12, wobei die aktive Schaltung (115) einen Stromversorgungsknoten (G) aufweist, der über einen Schalter (231) mit der ersten Elektrode (B) des kapazitiven Speicherelements (105) gekoppelt ist, und wobei die Einheit eine Steuerschaltung (241) aufweist, die geeignet ist, den Schalter (231) in den Ein-Zustand zu steuern, wenn die Spannung über dem kapazitiven Element (105) den ersten Schwellenwert übersteigt.

14. Einheit nach Anspruch 13, wobei die Steuerschaltung (241) ferner geeignet ist, den Schalter (231) wieder in den Aus-Zustand zu steuern, wenn die Spannung über dem kapazitiven Element (105) unter einen zweiten Schwellenwert fällt, der niedriger als der erste Schwellenwert ist.

15. System, das eine oder eine Vielzahl von Messeinheiten (100) nach einem der Ansprüche 1 bis 14 und eine Datenerfassungseinheit aufweist, die geeignet ist, die von jeder Einheit (100) gesendeten Ereignisanzeigesignale zu empfangen und eine Zeitmenge zu messen, die für die Übertragungsfrequenz der Ereignisanzeigesignale durch jede Einheit repräsentativ ist.

## Claims

1. A measurement unit (100) comprising:
an electric ambient energy recovery generator (103);
an element (105) of capacitive storage of the electric energy generated by the generator;
an electric battery (107);
a first branch (B1) coupling an output node (A) of the generator (103) to a first electrode (B) of the capacitive storage element (105);
a second branch (B2) coupling a first terminal (C) of the battery (107) to the first electrode of the capacitive storage element (105); and
an active circuit (115) capable of transmitting a radio event indicator signal each time the voltage across the capacitive storage element (105) exceeds a first threshold,
wherein, in operation, the capacitive storage element (105) simultaneously receives, on its first electrode, a first charge current (IB1) originating from the generator via the first branch, and a second charge current (IB2) originating from the battery (107) via the second branch.

2. The unit of claim 1, wherein the first branch (B1) comprises a first resistor (Rt1) and the second branch (B2) comprises a second resistor (Rt2).

3. The unit of claim 1 or 2, wherein the second branch (B2) comprises a circuit (109) for protecting the battery (107) against an over-discharge.

4. The unit of claim 3, wherein the circuit (109) for protecting the battery (107) against an over-discharge comprises a transistor (321) coupling the first terminal (C) of the battery (107) to the first electrode (B) of the capacitive storage element (105), and a circuit (323, 326, 327, 324; 536, 537, 538) capable of controlling this transistor (321) to the on state when the voltage across the battery is higher than a low limit below which the battery would risk being damaged, and to the off state when the voltage across the battery is lower than said low limit.

5. The unit of any of claims 1 to 4, wherein the first branch (B1) comprises a diode (D1) oriented in the forward direction between the output node (A) of the generator (103) and the first electrode (B) of the capacitive storage element (105).

6. The unit of any of claims 1 to 5, wherein the second branch comprises a diode (D2) oriented in the forward direction between the first terminal (C) of the battery (107) and the first electrode of the capacitive storage element (105).

7. The unit of any of claims 1 to 6, further comprising a third branch (B3) coupling the output node (A) of the generator (103) to the first terminal (C) of the battery (107).

8. The unit of claim 7, wherein the third branch (B3) comprises a circuit (113) for protecting the battery (107) against an overcharge.

9. The unit of claim 8, wherein the circuit (113) for protecting the battery (107) against an overcharge comprises a transistor (311; 411; 303) coupling the output node (A) of the generator (103) to the first terminal (C) of the battery (107) and a circuit (313, 316, 317, 314; 413, 416, 417, 414; 536, 537, 538) capable of controlling this transistor (311; 411; 303) to the on state when the voltage across the battery is lower than an upper limit above which the battery would risk being damaged, and to the off state when the voltage across the battery is higher than said upper limit.

10. The unit of any of claims 7 to 9, wherein the third branch (B3) further comprises a circuit (111) for limiting the charge current applied to the battery (107).

11. The unit of claim 10, wherein the current-limiting circuit (111) comprises a transistor (303) and a circuit (301, 307; 305) capable of controlling this transistor in linear state so that the resistance of the transistor is all the higher as the current applied by the generator (103) in the third branch is high.

12. The unit of any of claims 7 to 11, wherein the third branch further comprises a diode (D3) oriented in the forward direction between the output node (A) of the generator (103) and the first terminal (C) of the battery (107).

13. The unit of any of claims 1 to 12, wherein the active circuit (115) has a power supply node (G) coupled to the first electrode (B) of the capacitive storage element (105) via a switch (231), and wherein the unit comprises a control circuit (241) capable of controlling the switch (231) to the on state when the voltage across the capacitive element (105) exceeds said first threshold.

14. The unit of claim 13, wherein the control circuit (241) is further capable of controlling the switch (231) back to the off state when the voltage across the capacitive element (105) falls below a second threshold lower than the first threshold.

15. A system comprising one or a plurality of measurement units (100) of any of claims 1 to 14, and a data collection unit capable of receiving the event indicator signals transmitted by each unit (100), and of measuring a time quantity representative of the frequency of transmission of the event indicator signals by each unit.
